# EUROPEAN PATENT APPLICATION

(11) **EP 3 998 434 A1**
(43) Date of publication of application: **18.05.2022**
(21) Application number: 19937129.5
(22) Date of filing: 09.07.2019
(51) Int. Cl.: F25B 1/00, F24F 7/06, G06F 1/20

(54) **COOLING SYSTEM, SURGE GENERATION PREVENTION DEVICE, SURGE GENERATION PREVENTION METHOD, AND SURGE GENERATION PREVENTION PROGRAM**

(71) Applicant: NEC Corporation, 108-8001 Tokyo (JP)
(72) Inventor: MIYAMOTO, Yoshinori, Tokyo 108-8001 (JP); NATSUMEDA, Takafumi, Tokyo 108-8001 (JP); YOSHIKAWA, Minoru, Tokyo 108-8001 (JP)
(74) Representative: Vossius & Partner Patentanwälte Rechtsanwälte mbB
(86) International application number: PCT/JP2019/027113
(87) International publication number: WO 2021/005705

(57) **Abstract**

An object of this invention is to prevent the generation of a surge phenomenon in a compressor by being able to respond quickly even when the load of servers to be cooled changes rapidly. In the present invention, a local cooler (1) is positioned near a server (S) that serves as a heat source and is consequently able to directly receive heat from the server (S) and quickly change the state of a refrigerant in accordance with the heat of the server (S). The present invention is characterized by having refrigerant state detection means (6) that detects the state of a gas-phase refrigerant supplied from the local cooler (1), and a proportional control valve (8) and a high-speed on-off valve (9) that are provided in parallel with a bypass route (7) of a compressor (2) and operated on the basis of a refrigerant state ratio calculated from detection values of the refrigerant state detection means (6), the proportional control valve (8) is such that an opening degree is controlled in a stepwise manner on the basis of the refrigerant state ratio of the compressor (2), and the high-speed on-off valve (9) is operated to open and close on the basis of the refrigerant state ratio of the compressor (2) and is set to have a larger change in opening degree per unit time than the proportional control valve (8).

## Description

### TECHNICAL FIELD

The present invention relates to a cooling system, a surge control device, a surge generation prevention method, and a surge generation prevention program for efficiently exhausting heat from an electronic device that serves as a heat source.

### BACKGROUND ART

As a technique for performing air conditioning, for example, an air conditioning device shown in Patent Document 1 is known.

Patent Document 1 is an air conditioner including a compressor and an electric valve provided in a bypass pipe connecting the discharge side and the suction side of the compressor, and the electric valve is a valve whose opening degree can be freely adjusted, being configured to include an on-off valve connected to the bypass pipe in parallel with the electric valve.

### Prior Art Documents

### Patent Documents

Patent Document 1: Japanese Unexamined Patent Application, First Publication No. 2017-20722

### SUMMARY OF THE INVENTION

### Problem to be solved by the Invention

While the technique shown in Patent Document 1 prevents the refrigerant pressure from becoming too high as the air conditioning load decreases, the technique is only used for indoor air conditioning, and the configuration was not suited to use in a server room in a data center where electronic devices are densely packed.

That is, since the basic configuration of Patent Document 1 is an air conditioner, there are the problems of the response being poor when the load of the servers to be cooled changes suddenly, and being unable to respond quickly to a sudden decrease in refrigerant pressure. Therefore, proposals for new technologies to comprehensively solve the problem have been expected.

The present invention has been made in view of the above circumstances, and has as its object to provide a cooling system, a surge control device, a surge generation prevention method, and a surge generation prevention program that can prevent the generation of a surge phenomenon in a compressor by being able to respond quickly even when the load of a server to be cooled changes rapidly.

### Means for Solving the Problem

In order to solve the aforementioned problems, the present invention proposes the following means.

A cooling system according to a first example aspect of the present invention includes: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; and an expansion valve that depressurizes the refrigerant supplied from the outdoor unit and sends the refrigerant to the local cooler, and further includes: a pair of refrigerant state detection means that are respectively provided at an inlet side and an outlet side of the compressor and detect a state of the gas-phase refrigerant supplied from the local cooler; and a proportional control valve and a high-speed on-off valve that are provided in parallel with a bypass route of the compressor and are operated based on a refrigerant state ratio calculated from a detection value of the refrigerant state detection means, the proportional control valve is such that an opening degree is controlled in a stepwise manner based on the refrigerant state ratio of the compressor, and the high-speed on-off valve is operated to open and close based on the refrigerant state ratio of the compressor and is set to have a larger change in opening degree per unit time than the proportional control valve.

A surge generation prevention device according to a second example aspect of the present invention includes: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; an expansion valve that depressurizes the refrigerant supplied from the outdoor unit and sends the refrigerant to the local cooler; a pair of refrigerant state detection means that are respectively provided at an inlet side and an outlet side of the compressor and detect a state of the gas-phase refrigerant supplied from the local cooler; and a proportional control valve and a high-speed on-off valve that are provided in parallel with a bypass route of the compressor and are operated based on a refrigerant state ratio calculated from a detection value of the refrigerant state detection means, the calculation control unit calculates a state ratio of the refrigerant in a vapor pipe on an outlet side with respect to a vapor pipe on an inlet side of the compressor from the detection value of the refrigerant state detection means, and controls the proportional control valve and the high-speed on-off valve depending on whether or not the state ratio goes beyond a preset reference value.

In a surge generation prevention method according to a third example aspect of the present invention, in a cooling system including: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; and an expansion valve that depressurizes the refrigerant supplied from the outdoor unit and sends the refrigerant to the local cooler, the surge generation prevention method includes: a refrigerant state detection step of detecting a state of the gas-phase refrigerant supplied from the local cooler with respectively provided at an inlet side and an outlet side of the compressor; a calculation step of calculating a state ratio of the refrigerant in a vapor pipe on the outlet side of the compressor with respect to a vapor pipe on the inlet side from a detection value obtained in the refrigerant state detection step; a first valve adjustment step of adjusting an opening degree of a proportional control valve in a stepwise manner so that the refrigerant state ratio obtained in the calculation step matches or approximates a preset standard target value, the proportional control valve being arranged in parallel with the compressor; and a second valve adjustment step of opening the high-speed on-off valve when the refrigerant state ratio obtained in the calculation step goes beyond a preset upper threshold value, and closing the high-speed on-off valve when the refrigerant state ratio goes beyond a preset lower limit threshold value, the high-speed on-off valve being arranged in parallel with the compressor and the proportional control valve.

In surge generation prevention program according to a fourth example aspect of the present invention, in a cooling system including: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; and an expansion valve that depressurizes the refrigerant supplied from the outdoor unit and sends the refrigerant to the local cooler, the surge generation prevention program comprises: a refrigerant state detection step of detecting a state of the gas-phase refrigerant supplied from the local cooler with respectively provided at an inlet side and an outlet side of the compressor; a calculation step of calculating a state ratio of the refrigerant in a vapor pipe on the outlet side of the compressor with respect to a vapor pipe on the inlet side from a detection value obtained in the refrigerant state detection step; a first valve adjustment step of adjusting an opening degree of a proportional control valve in a stepwise manner so that the refrigerant state ratio obtained in the calculation step matches or approximates a preset standard target value, the proportional control valve being arranged in parallel with the compressor; and a second valve adjustment step of opening the high-speed on-off valve when the refrigerant state ratio obtained in the calculation step goes beyond a preset upper threshold value, and closing the high-speed on-off valve when the refrigerant state ratio goes beyond a preset lower limit threshold value, the high-speed on-off valve being arranged in parallel with the compressor and the proportional control valve.

### Effect of the Invention

In the present invention, even if the state of a refrigerant in a server room suddenly changes due to load fluctuation arising from partial stoppage of servers, expansion of servers, maintenance, or the like, it is possible to quickly respond, and it is possible to prevent the occurrence of a surge phenomenon that causes compressor failure.

### BRIEF DESCRIPTION OF THE DRAWINGS

FIG. 1 is a schematic configuration diagram of a cooling system according to the present invention.
FIG. 2 is a schematic configuration diagram of a cooling system according to a first example embodiment of the present invention.
FIG. 3 is a diagram showing a peripheral configuration of a compressor in the cooling system of FIG. 2.
FIG. 4 is a diagram according to a second example embodiment of the present invention, showing the relationship between a compression ratio calculated from pressure gauges and the opening/closing operation of a proportional control valve and a high-speed on-off valve.

### EXAMPLE EMBODIMENT

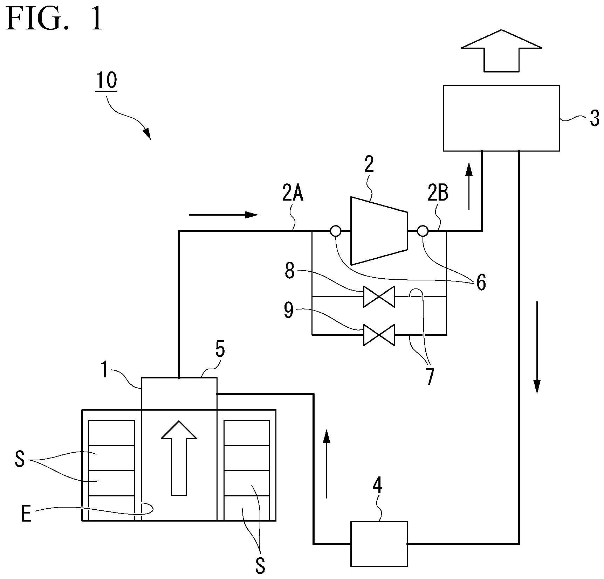

A cooling system 10 according to the present invention will be described with reference to FIG. 1.

The cooling system 10 mainly includes a local cooler 1, a compressor 2, an outdoor unit 3, and an expansion valve 4.

The local cooler 1 has a heat exchange unit 5 that is positioned near servers S that are heat sources in a server room (a position above an exhaust area E located between the servers S in the figure) to directly receive heat from the servers S. The heat exchange unit 5 of the local cooler 1 exhausts heat from the servers S by evaporating an internal liquid-phase refrigerant with the heat of the servers S.

The compressor 2 is for compressing the gas-phase refrigerant produced in the local cooler 1 and forcibly sending the refrigerant to the outdoor unit 3.

The outdoor unit 3 is for condensing the gas-phase refrigerant by dissipating to an external space the heat of the gas-phase refrigerant supplied from the compressor 2.

The expansion valve 4 is for depressurizing the refrigerant supplied from the outdoor unit 3 to obtain a complete liquid-phase refrigerant, and afterward sending the refrigerant to the local cooler 1.

A pair of refrigerant state detection means 6 that detect the state (= the pressure, flow rate, temperature, vibration, etc.) of the gas-phase refrigerant supplied from the local cooler 1 are provided at a vapor pipe 2A on the inlet side and a vapor pipe 2B on the outlet side of the compressor 2.

As the refrigerant state detection means 6, a pressure gauge for detecting the pressure of the gas-phase refrigerant, a flowmeter for detecting the flow rate of the gas-phase refrigerant, a thermometer for detecting the temperature of the gas-phase refrigerant, and a vibrometer for detecting abnormal vibration from the compressor 2 are used.

A proportional control valve 8 and a high-speed on-off valve 9 that are operated based on a refrigerant state ratio calculated from the detection values of the refrigerant state detection means 6 are installed in a bypass route 7 arranged in parallel with the compressor 2.

The proportional control valve 8 is a valve whose opening degree is controlled in a stepwise manner based on the refrigerant state ratio of the compressor 2.

The high-speed on-off valve 9 is a valve that is operated to be opened or closed based on the refrigerant state ratio of the compressor 2 and is set to have a larger change in opening degree per unit time than the proportional control valve 8.

According to the cooling system 10 according to the present invention described above, since the local cooler 1 is positioned near the servers S that serve as heat sources, it is possible to directly receive heat from the servers S and quickly change the state of the refrigerant in accordance with the heat of the servers S.

In the cooling system 10, a pair of refrigerant state detection means 6 that detect the state (= the pressure, flow rate, temperature, vibration, etc.) of the gas-phase refrigerant supplied from the local cooler 1 are provided in the inlet-side vapor pipe 2A and the outlet-side vapor pipe 2B of the compressor 2, and the proportional control valve 8 and the high-speed on-off valve 9, which operate on the basis of the refrigerant state ratio calculated from the detection values of the refrigerant state detection means 6, are installed to be parallel to the bypass routes 7 of the compressor 2.

The proportional control valve 8 is controlled so as to have a stepwise opening degree based on the refrigerant state ratio calculated from the detection value of the refrigerant state detection means 6, and the high-speed on-off valve 9 is open or close controlled so as to have a larger change in opening degree per unit time than the proportional control valve 8 based on the refrigerant state ratio calculated from the detection value of the refrigerant state detection means 6.

Thereby, in the cooling system 10 it is possible to quickly perform the valve operation by the high-speed on-off valve 9 to eliminate the abnormal state of the refrigerant and the valve control by the proportional control valve 8 to maintain the normal state of the refrigerant based on the refrigerant state ratio calculated from the detection value of the refrigerant state detection means 6.

As a result, in the cooling system 10 according to the present invention, even if the state of the refrigerant suddenly changes due to load fluctuation arising from partial stoppage of the servers S, addition of servers, maintenance, or the like in the server room, a prompt response is possible, and it is possible to prevent the occurrence of a surge phenomenon that is a cause of failure in the compressor 2.

### (First Example Embodiment)

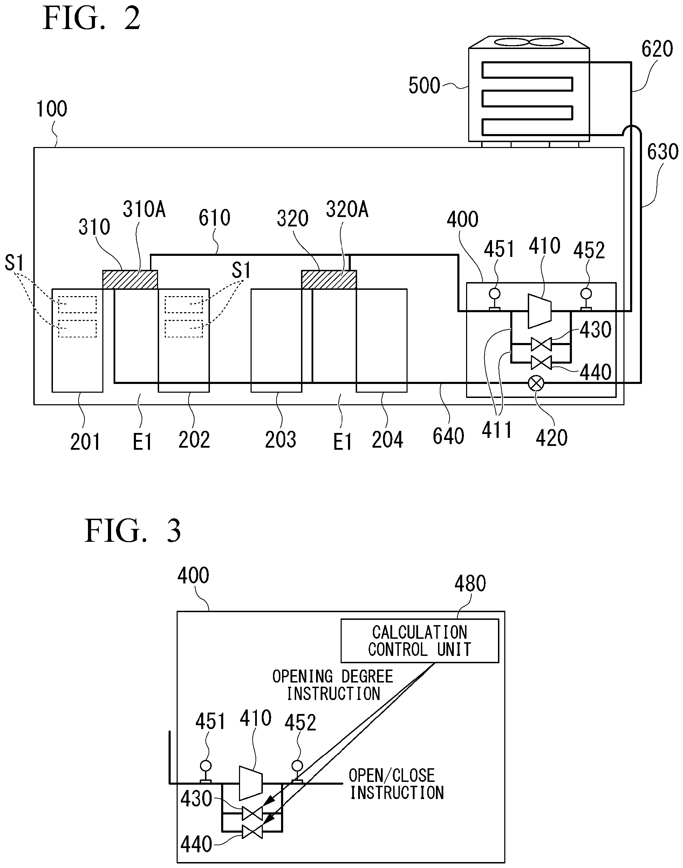

The system diagram of the cooling system 101 according to the first example embodiment of the present invention will be described with reference to FIG. 2 and FIG. 3.

The cooling system 101 according to the first example embodiment mainly includes local coolers 310 and 320, a compressor 410, an outdoor unit 500, and an expansion valve 420.

In these components, the local coolers 310 and 320, the compressor 410 and the outdoor unit 500 are connected by vapor pipes 610 and 620, while the outdoor unit 500, the expansion valve 420 and the local coolers 310 and 320 are connected by liquid pipes 630 and 640.

In the cooling system 101, components other than the outdoor unit 500 are arranged in the server room 100.

In the cooling system 101, the compressor 410 and the expansion valve 420 in the server room 100 are installed in an indoor unit 400.

The local coolers 310 and 320 are positioned near servers S1, which serve as heat sources in the server room, and have heat exchange units 310A and 320A which directly receive the heat from the servers S1.

A plurality of the servers S1 are housed in server racks 201 to 204 arranged at regular intervals, and the heat is discharged toward an exhaust area E1 located between the server racks 201 to 204.

The heat exchange units 310A and 320A of the local coolers 310 and 320 are located above the exhaust area E1 between the server racks 201 to 204, and by evaporating the internal liquid-phase refrigerant with the heat of the servers S1, exhaust the heat from the exhaust area E1.

The compressor 410 is for compressing the gas-phase refrigerant generated in the local coolers 310 and 320 and forcibly sending the gas-phase refrigerant to the outdoor unit 500.

For example, a turbo compressor in which a plurality of impellers are arranged around a rotating shaft is used as the compressor 410, and by compressing and pressurizing the gas-phase refrigerant taken in from the suction nozzle with the centrifugal force when passing through the inside of a high-speed rotating impellers, the gas-phase refrigerant is discharged from the exhaust nozzle.

The outdoor unit 500 is for condensing the gas-phase refrigerant by discharging to the external space heat of the gas-phase refrigerant supplied from the compressor 410.

The expansion valve 420 is for depressurizing the refrigerant supplied from the outdoor unit 500 to obtain a complete liquid-phase refrigerant and then sending the liquid-phase refrigerant to the local coolers 310 and 320.

Then, in the cooling system 101 configured as described above, the refrigerant evaporates in the heat exchange units 310A and 320A of the local coolers 310 and 320 individually installed above the exhaust area E1 of the server racks 201 to 204, whereby the heat contained in the exhaust of the servers S1 can be absorbed.

As a result, by converting the exhaust gas of the server racks 201 to 204 into cold air with the local coolers 310 and 320, the entire server room 100 can be efficiently cooled before the heat diffuses throughout the entire room.

The refrigerant evaporated in the local coolers 310 and 320 is subsequently sent to the compressor 410 through the vapor pipe 610. The refrigerant that has become a high temperature and high pressure by the compressor 410, is condensed by the heat dissipation to the outside air in the outdoor unit 500, and passes through the liquid pipe 630 to move to the expansion valve 420. The refrigerant depressurized in the expansion valve 420 becomes a liquid-phase refrigerant to be supplied again to the local coolers 310 and 320.

In the cooling system 101, a pair of pressure gauges 451 and 452 that detect the pressure of the gas-phase refrigerant supplied from the local coolers 310 and 320 are provided in the vapor pipe 610 located on the inlet side and the vapor pipe 620 located on the outlet side of the compressor 410.

Further, the vapor pipes 610 and 620 provided with the pressure gauges 451 and 452 are provided with two bypass routes 411 that are vapor flow paths in parallel with the compressor 410.

A proportional control valve 430 and a high-speed on-off valve 440 that operate based on a compression ratio calculated from the detection values of the pressure gauges 451 and 452 are installed in these two bypass routes 411, respectively.

A motor electric valve is used as the proportional control valve 430, and a solenoid valve is used as the high-speed on-off valve 440.

Then, the proportional control valve 430 is controlled to have a stepwise opening degree based on the compression ratio calculated from the detection values of the pressure gauges 451 and 452, and the high-speed on-off valve 440 is open or close controlled so as to have a larger change in opening degree per unit time than the proportional control valve 430 based on the compression ratio calculated from the detection values of the pressure gauges 451 and 452.

The calculation of the compression ratio based on the detection values of the pressure gauges 451 and 452 and the operation of the proportional control valve 430 and the high-speed on-off valve 440 based on the calculated compression ratio are performed by a calculation control unit 480 shown in FIG. 3.

Specifically, the calculation control unit 480 calculates the compression ratio of the refrigerant at the outlet side vapor pipe 620 of the compressor 410 with respect to the inlet side vapor pipe 610 from the detection values of the pressure gauges 451 and 452, and on the basis of that calculation result controls the proportional control valve 430 and the high-speed on-off valve 440.

Thereby, in the cooling system 101 it is possible to quickly perform the valve operation by the high-speed on-off valve 440 to eliminate the abnormal state of the refrigerant and the valve control by the proportional control valve 430 to maintain the normal state of the refrigerant based on the compression ratio calculated from the detected values of the pressure gauges 451 and 452.

As a result, in the cooling system 101 according to the present example embodiment, even if the state of the refrigerant suddenly changes due to load fluctuation arising from partial stoppage of the servers S1, addition of servers, maintenance, and the like in the server room, a prompt response is possible, and it is possible to prevent the occurrence of a surge phenomenon that is a cause of failure in the compressor 410.

In the above example embodiment, pressure gauges for detecting the pressure of the gas-phase refrigerant are installed as the refrigerant state detection means located on the inlet side and the outlet side of the compressor 410.

However, the means for detecting the state of the refrigerant is not limited to a pressure gauge, and a flowmeter for detecting the flow rate of the gas-phase refrigerant, a thermometer for detecting the temperature of the gas-phase refrigerant, and a vibrometer for detecting abnormal vibration from the compressor 410 can also be used.

### (Second Example Embodiment)

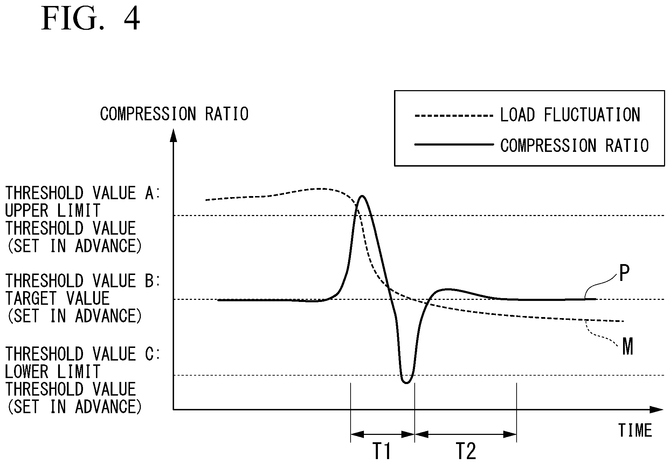

A cooling system 101 according to the second example embodiment of the present invention will be described with reference to FIG. 4, which shows different control modes in the same equipment and a pipe as the cooling system according to FIGS. 2 and 3.

In the cooling system 101 according to the second example embodiment, the operating conditions of the proportional control valve 430 and the high-speed on-off valve 440 shown in the first example embodiment are shown by the graph shown in FIG. 4.

Specifically, in FIG. 4, a compression ratio of refrigerant at the outlet side vapor pipe 620 of the compressor 410 with respect to the inlet side vapor pipe 610, which is calculated from the detection values of the pressure gauges 451 and 452, is indicated by the reference symbol "P". In the same figure, the load fluctuation of the compressor 410 is indicated by the reference symbol "M".

Then, the calculation control unit 480 controls the proportional control valve 430 and the high-speed on-off valve 440 so that the refrigerant compression ratio P calculated from the detection values of the pressure gauges 451 and 452 becomes a standard target value (B) which is a preset reference.

More specifically, the calculation control unit 480 performs stepwise feedback control of the opening degree of the proportional control valve 430 so that the refrigerant compression ratio P matches or approximates the preset standard target value (B) during the normal operation of the cooling system 101 (control of the range indicated by reference symbol T2 in FIG. 4).

Further, when a sudden load fluctuation of the compressor 410 has occurred, for example, when the servers S1 are partially stopped, the calculation control unit 480 opens the high-speed on-off valve 440 of the bypass route 411 to prevent the liquid component of the refrigerant from passing through the compressor 410 (control of the range indicated by reference symbol T1 in FIG. 4).

The calculation control unit 480 determines there is a rise in load fluctuation of the compressor 410 by whether or not the refrigerant compression ratio P has reached an upper limit threshold value (A), and based on the determination result, outputs an instruction to open the high-speed on-off valve 440 of the bypass route 411. This prevents the hunting phenomenon from occurring in the compressor 410.

When for example the load fluctuation of the compressor 410 described above has settled, the calculation control unit 480 closes the high-speed on-off valve 440 of the bypass route 411 to prevent the refrigerant from passing through the bypass route 411.

At this time, the calculation control unit 480 makes a determination of the settlement of such a load fluctuation of the compressor 410 by whether or not the refrigerant compression ratio P has reached a lower limit threshold value (C), and outputs an instruction to close the high-speed on-off valve 440 of the bypass route 411 based on that determination result.

That is, when the refrigerant compression ratio P of the outlet side vapor pipe 620 of the compressor 410 with respect to the inlet side vapor pipe 610 exceeds the preset upper limit threshold value (A) (when the load fluctuation has risen), the calculation control unit 480 of the cooling system 101 according to the second example embodiment outputs an instruction to open the high-speed on-off valve 440, and when the refrigerant compression ratio P falls below the preset lower limit threshold value (C) (when the load fluctuation has dropped), it outputs an instruction to close the high-speed on-off valve 440 is output.

As a result, the cooling system 101 according to the second example embodiment can prevent excessive load fluctuation from occurring in the compressor 410 and prevent the occurrence of the surge phenomenon in the turbo compressor 410 by stepwise feedback control of the opening degree of the proportional control valve 430 and instantaneous opening/closing control of the high-speed on-off valve 440 based on the refrigerant compression ratio P detected by the pressure gauges 451 and 452.

In the cooling system 101, the turbo compressor 410 and the expansion valve 420 are installed in the indoor unit 400 in the server room 100, but may be arranged outside the server room 100 together with the outdoor unit 500.

The local coolers 310 and 320, although installed above the server racks 201 to 204, may be directly installed on the back surface of the server racks 201 to 204. Moreover, the number of these server racks 201 to 204 are not limited to those shown in the drawings.

In the above example embodiments, while the high-speed on-off valve 440 is controlled to open/close depending on whether or not the refrigerant compression ratio P reaches the upper limit threshold value (A) or the lower limit threshold value (C), it is preferable that the setting of the upper limit threshold value (A) or the lower limit threshold value (C) be freely changeable by the operator.

In the cooling system 101, a surge generation prevention method or surge generation prevention program is adopted having of
a refrigerant state detection step of detect the state of the gas-phase refrigerant supplied from the local coolers 310 and 320 with being respectively provided at the inlet side vapor pipe 610 and the outlet side vapor pipe 620 of the compressor 410, a calculation step of calculating the refrigerant state ratio (P) of the outlet side vapor pipe 620 with respect to the inlet side vapor pipe 610 of the compressor 410 from the detection values obtained in the refrigerant state detection step, a first valve adjustment step of stepwisely adjusting the opening degree of the proportional control valve 430 arranged in parallel with the compressor 410 so that the refrigerant state ratio (P) obtained in the calculation step matches or approximates the preset standard target value (B), and a second valve adjustment step of performing opening operation on the high-speed on-off valve 440 arranged in parallel with the compressor 410 and the proportional control valve 430 when the refrigerant state ratio (P) obtained in the calculation step goes beyond the preset upper limit threshold value (A), and performing closing operation on the high-speed on-off valve 440 when the refrigerant state ratio (P) goes beyond a preset lower limit threshold value (C).

Although example embodiments of the present invention have been described in detail with reference to the drawings, specific configurations are not limited to these example embodiments, and design changes and the like within a range not deviating from the gist of the present invention are also included.

### INDUSTRIAL APPLICABILITY

The present invention can be used in a cooling system for efficiently cooling an electronic device, a surge generation prevention device, a surge generation prevention method, and a surge generation prevention program.

### Description of Reference Symbols

1: Local cooler
2: Turbo compressor
3: Outdoor unit
4: Expansion value
5: Heat exchange unit
6: Refrigerant state detection means
7: Bypass route
8: Proportional control valve
9: High-speed on-off valve
10: Cooling system
100: Server room
101: Cooling system
201: Server rack
202: Server rack
203: Server rack
204: Server rack
310: Local cooler
320: Local cooler
410: Compressor
411: Bypass route
420: Expansion valve
430: Proportional control valve
440: High-speed on-off valve
451: Pressure gauge
452: Pressure gauge
S: Server
S1: Server
E: Exhaust area
E1: Exhaust area

## Claims

1. A cooling system comprising: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; and an expansion valve that depressurizes the refrigerant supplied from the outdoor unit and sends the refrigerant to the local cooler,
further comprising: a pair of refrigerant state detection means that are respectively provided at an inlet side and an outlet side of the compressor and detect a state of the gas-phase refrigerant supplied from the local cooler; and
a proportional control valve and a high-speed on-off valve that are provided in parallel with a bypass route of the compressor and are operated based on a refrigerant state ratio calculated from a detection value of the refrigerant state detection means,
wherein the proportional control valve is such that an opening degree is controlled in a stepwise manner based on the refrigerant state ratio of the compressor, and
the high-speed on-off valve is operated to open and close based on the refrigerant state ratio of the compressor and is set to have a larger change in opening degree per unit time than the proportional control valve.

2. The cooling system according to claim 1, wherein the local cooler includes a heat exchanger that is installed above an exhaust area between server racks and that directly receives the heat from the server serving as the heat source.

3. The cooling system according to either one of claims 1 or 2, wherein the refrigerant state detection means is a pressure detection means that detects a pressure of the refrigerant in a pipe located on the inlet side and the outlet side of the compressor.

4. The cooling system according to either one of claims 1 or 2, wherein the refrigerant state detection means is a flow rate detection means that detects a flow rate of the refrigerant in a pipe located on the inlet side and the outlet side of the compressor.

5. The cooling system according to any one of claims 1 to 4,
wherein the proportional control valve and the high-speed on-off valve include a calculation control unit, and
the calculation control unit calculates a state ratio of the refrigerant in a vapor pipe on the outlet side of the compressor with respect to a vapor pipe on the inlet side from the detection value of the refrigerant state detection means, and controls the proportional control valve and the high-speed on-off valve based on the calculation result.

6. The cooling system according to claim 5, wherein the calculation control unit adjusts in a stepwise manner the opening degree of the proportional control valve so that the state ratio of the refrigerant matches or approximates a preset standard target value.

7. The cooling system according to either one of claims 5 or 6, wherein the calculation control unit operates the high-speed on-off valve to open when the state ratio of the refrigerant goes beyond and becomes higher than a preset upper limit threshold value, and operates the high-speed on-off valve to close when the state ratio of the refrigerant goes beyond and becomes lower than a preset lower limit threshold value.

8. A surge generation prevention device comprising:
a local cooler that is positioned near a server serving as a heat source and that evaporates a refrigerant by directly receiving heat from the server;
a compressor that compresses the gas-phase refrigerant generated in the local cooler;
an outdoor unit that condenses the gas-phase refrigerant supplied from the compressor by dissipating heat from the gas-phase refrigerant;
an expansion valve that depressurizes the refrigerant supplied from the outdoor unit and sends the refrigerant to the local cooler;
a pair of refrigerant state detection means that are respectively provided at an inlet side and an outlet side of the compressor and detect a state of the gas-phase refrigerant supplied from the local cooler; and
a proportional control valve and a high-speed on-off valve that are provided in parallel with a bypass route of the compressor and are operated based on a refrigerant state ratio calculated from a detection value of the refrigerant state detection means,
wherein the calculation control unit calculates a state ratio of the refrigerant in a vapor pipe on an outlet side with respect to a vapor pipe on an inlet side of the compressor from the detection value of the refrigerant state detection means, and controls the proportional control valve and the high-speed on-off valve depending on whether or not the state ratio goes beyond a preset reference value.

9. A surge generation prevention method in a cooling system, the cooling system comprising: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; and an expansion valve that depressurizes the refrigerant supplied from the outdoor unit and sends the refrigerant to the local cooler, the surge generation prevention method comprising:
a refrigerant state detection step of detecting a state of the gas-phase refrigerant supplied from the local cooler with respectively provided at an inlet side and an outlet side of the compressor;
a calculation step of calculating a state ratio of the refrigerant in a vapor pipe on the outlet side of the compressor with respect to a vapor pipe on the inlet side from a detection value obtained in the refrigerant state detection step;
a first valve adjustment step of adjusting an opening degree of a proportional control valve in a stepwise manner so that the refrigerant state ratio obtained in the calculation step matches or approximates a preset standard target value, the proportional control valve being arranged in parallel with the compressor; and
a second valve adjustment step of opening the high-speed on-off valve when the refrigerant state ratio obtained in the calculation step goes beyond a preset upper threshold value, and closing the high-speed on-off valve when the refrigerant state ratio goes beyond a preset lower limit threshold value, the high-speed on-off valve being arranged in parallel with the compressor and the proportional control valve.

10. A surge generation prevention program in a cooling system, the cooling system comprising: a local cooler that is positioned near a server serving as a heat source and that evaporates a refrigerant by directly receiving heat from the server; a compressor that compresses the gas-phase refrigerant generated in the local cooler; an outdoor unit that condenses the gas-phase refrigerant supplied from the compressor by dissipating heat from the gas-phase refrigerant; and an expansion valve that depressurizes the refrigerant supplied from the outdoor unit and sends the refrigerant to the local cooler, the surge generation prevention program comprising:
a refrigerant state detection step of detecting a state of the gas-phase refrigerant supplied from the local cooler with respectively provided at an inlet side and an outlet side of the compressor;
a calculation step of calculating a state ratio of the refrigerant in a vapor pipe on the outlet side of the compressor with respect to a vapor pipe on the inlet side from a detection value obtained in the refrigerant state detection step;
a first valve adjustment step of adjusting an opening degree of a proportional control valve in a stepwise manner so that the refrigerant state ratio obtained in the calculation step matches or approximates a preset standard target value, the proportional control valve being arranged in parallel with the compressor; and
a second valve adjustment step of opening the high-speed on-off valve when the refrigerant state ratio obtained in the calculation step goes beyond a preset upper threshold value, and closing the high-speed on-off valve when the refrigerant state ratio goes beyond a preset lower limit threshold value, the high-speed on-off valve being arranged in parallel with the compressor and the proportional control valve.
